(19)

**Europäisches Patentamt**
**European Patent Office**
**Office européen des brevets**

(11) **EP 1 923 931 A2**

(12) **EUROPEAN PATENT APPLICATION**

(43) Date of publication:
   **21.05.2008 Bulletin 2008/21**

(51) Int Cl.:
   **H01L 51/52** (2006.01)

(21) Application number: **07254515.5**

(22) Date of filing: **20.11.2007**

(84) Designated Contracting States:
   **AT BE BG CH CY CZ DE DK EE ES FI FR GB GR HU IE IS IT LI LT LU LV MC MT NL PL PT RO SE SI SK TR**
   Designated Extension States:
   **AL BA HR MK RS**

(30) Priority: **20.11.2006 JP 2006312748**

(71) Applicant: **Lintec Corporation**
   **Tokyo 173-0001 (JP)**

(72) Inventors:
   • **Hoshi, Shinichi,**
   **c/o Lintec Corporation**
   **Tokyo 173-0001 (JP)**

   • **Okuji, Shigeto,**
   **c/o Lintec Corporation**
   **Tokyo 173-0001 (JP)**
   • **Sekiya, Masahiko,**
   **c/o Lintec Corporation**
   **Tokyo 173-0001 (JP)**

(74) Representative: **Nicholls, Michael John**
   **J.A. Kemp & Co.**
   **14, South Square**
   **Gray's Inn**
   **London WC1R 5JJ (GB)**

(54) **Luminescent sheet and method of producing the same**

(57) This invention relates to a luminescent sheet obtained by allowing a sheet capable of causing luminescence to be subjected to perforation processing; and a method of producing the luminescent sheet, wherein the luminescent sheet is subjected to perforation processing involving drilling, heated needle, punching, flat die cutting, rotary die cutting, laser processing, or the like.

According to the present invention, a low-power-consuming luminescent sheet obtained in a more convenient manner is provided.

**Fig. 2**

**EP 1 923 931 A2**

Printed by Jouve, 75001 PARIS (FR)

**Description**

An EL sheet is one example of the luminescent devices that have been recently gaining attention. EL sheets have been known to have the features of being easily produced and high durability. Thus, they have been used in a variety of fields relating to advertising media, lighting applications, decoration applications, backlight applications, and the like.

When used for the above applications, EL sheets are used for long periods of time in many cases, so that a serious problem regarding power consumption arises. Therefore, attempts have been made to achieve low power consumption with the use of techniques such as improving lighting efficiency by allowing a plurality of light sources to blink or by causing diffuse reflection of light as described in JP Patent Publication (Kokai) No. 11-45062 A (1999), JP Patent Publication (Kokai) No. 2005-108776 A, and JP Patent Publication (Kokai) No. 2002-196705 A. However, the methods disclosed in the above documents require highly complex configurations and drive control.

It is an objective of the present invention to provide a low-power-consuming luminescent sheet obtained in a more convenient manner.

The present invention is summarized as follows.

(1) A luminescent sheet obtained by allowing a sheet capable of causing luminescence to be subjected to perforation processing.
(2) The luminescent sheet according to item (1), wherein the sheet capable of causing luminescence is an electroluminescent sheet.
(3) The luminescent sheet according to item (1) or (2), wherein the hole area ratio is 5% to 80%.
(4) The luminescent sheet according to any one of items (1) to (3), wherein the hole diameter upon perforation processing is 0.1 to 20 mm and the length of the interval between the centers of holes is 0.2 to 50 mm.
(5) The luminescent sheet according to any one of items (1) to (4), which has been subjected to perforation processing in a matrix pattern.
(6) A method of producing the luminescent sheet according to any one of items (1) to (5), comprising allowing a sheet capable of causing luminescence to be subjected to perforation processing.
(7) The method according to item (6), wherein the means of perforation processing used is drilling, heated-needle processing, punching, flat die cutting, rotary die cutting, or laser processing.

According to the present invention, it is possible to provide a low-power-consuming luminescent sheet obtained in a more convenient manner.

Fig. 1 shows a cross-sectional view of an unperforated luminescent sheet.
Fig. 2 shows a state in which perforation processing is carried out from the 2nd electrode (back-side electrode) layer side.
Fig. 3 shows formulae for determining hole area ratios of the relevant perforation processing patterns.
Fig. 4 shows formulae for determining hole area ratios of the relevant perforation processing patterns (continued from fig. 3).

Each numeral in the figures means the following.

1 ---   transparent substrate
2 ---   1st electrode (transparent electrode) layer
3 ---   luminescent layer
4 ---   dielectric layer
5 ---   2nd electrode (back-side electrode) layer

The luminescent sheet of the present invention is a sheet capable of causing luminescence, which has been subjected to perforation processing. A low-power-consuming luminescent sheet can be obtained by carrying out perforation processing of a sheet capable of causing luminescence. Further, luminosity reduction can be significantly prevented by adjusting the hole diameter and the hole area ratio upon perforation processing.

Preferred examples of the above sheet capable of causing luminescence include electroluminescent sheets.

When an electroluminescent sheet is used as a sheet capable of causing luminescence, an example thereof is an electroluminescent sheet comprising a transparent substrate on which at least a 1st electrode (transparent electrode) layer, a luminescence layer, and a 2nd electrode (back-side electrode) layer are formed.

The aforementioned transparent substrate is not particularly limited as long as it is transparent. However, it is preferable that such transparent substrate be flexible. Examples of material used for such transparent substrate include:

polyester such as polyethylene terephthalate, polybutylene terephthalate, or polyethylene naphthalate; wholly aromatic polyamide; aliphatic polyamide such as nylon 6, nylon 66, or nylon copolymer; polymethyl methacrylate; and polycarbonate. The thickness of a substrate film to be used is not particularly limited and is generally 1 to 1000 $\mu$m, preferably 5 to 500 $\mu$m, and particularly preferably 50 to 200 $\mu$m for practical use.

Examples of material used for a 1st electrode layer include, but are not particularly limited to, metals, alloys, metal oxides, conductive organic compounds, and mixtures thereof. Specific examples thereof include: a semiconductive metal oxide such as tin oxide doped with antimony, fluorine, or the like (e.g., ATO or FTO), tin oxide, zinc oxide, indium oxide, indium tin oxide (ITO), or indium zinc oxide (IZO); a metal such as gold, silver, chromium, or nickel; a mixture or laminate of such metal and a conductive metal oxide; a conductive inorganic substance such as copper iodide or copper sulfide; conductive organic material such as polyaniline, polythiophene, or polypyrrole; and a laminate of the above examples and ITO. The thickness of the 1st electrode layer is generally 50 to 50000 nm.

A 1st electrode layer and a 2nd electrode layer can be formed on the above substrate according to a method that is adequately selected from, for example, the following methods based on applicability to the above material: wet methods such as a printing method and a coating method; physical methods such as a vacuum deposition method, a sputtering method, and an ion plating method; and chemical methods such as a thermal CVD (chemical vapor deposition) method, a plasma CVD method, and a photo-CVD method.

According to the present invention, a luminescent layer is provided between a 1st electrode layer and a 2nd electrode layer. A luminescent layer may be formed in a planar layer in a manner such that it covers one surface of each electrode layer. Alternatively, a luminescent layer may be partially provided.

Material used for a luminescent layer is not particularly limited as long as material that can cause the phenomenon of luminescence upon application of electric field is used. Examples of such material that may be used include: inorganic EL material such as activated zinc sulfide ZnS:X (wherein X is an activator element such as Mn, Tb, Cu, Sm, or Ag), $Y_2O_2S$:Eu, $Y_2O_3$:Eu, $Zn_2SiO_4$:Mn, $CaWO_4$:Pb, $BaMgAl_{10}O_{17}$:Eu, CaS:Eu, SrS:Ce, $SrGa_2S_4$:Ce, $CaGa_2S_4$:Ce, CaS:Pb, $BaAl_2S_4$:Eu, or $YVO_4$:Eu; low-molecular-weight organic EL material such as an aluminum-quinolinol complex or an aromatic diamine derivative (e.g., a triphenyldiamine derivative); and polymer organic EL material such as polyphenylene vinylene. The thickness of a luminescent layer is not particularly limited; however, it is generally 5 to 100 $\mu$m and preferably 10 to 80 $\mu$m in terms of the ease of handling. For instance, when inorganic EL material is used, preferred examples of a method of forming a luminescent layer include a bar coating method, a roll-knife coating method, a gravure coating method, a knife coating method, a spin coating method, a dip coating method, a screen printing method, a slide coating method, and a spraying method. When organic EL material is used, a vacuum deposition method and an inkjet method can be used.

According to the present invention, it is preferable to provide a dielectric layer for the improvement of luminescence efficiency. A dielectric layer is provided between a 1st electrode layer and a 2nd electrode layer and preferably between a luminescent layer and a 2nd electrode layer. Preferred examples of material used for a dielectric layer include insulated material with high dielectric constant such as $TiO_2$, $BaTiO_3$, $SrTiO_3$, $PbTiO_3$, $KNbO_3$, $PbNbO_3$, $Ta_2O_3$, $BaTa_2O_6$ $LiTaO_3$, $Y_2O_3$, $Al_2O_3$ $ZrO_2$, AlON, ZnS, silicon oxide, silicon nitride, or antimony-doped tin oxide. The thickness of a dielectric layer is not particularly limited; however, it is generally 5 to 100 $\mu$m and preferably 10 to 80 $\mu$m in terms of ease of handling. A dielectric layer can be formed on the above substrate according to a method adequately selected from, for example, the following methods based on applicability to the above material: wet methods such as a printing method and a coating method; physical methods such as a vacuum deposition method, a sputtering method, and an ion plating method; and chemical methods such as a thermal CVD (chemical vapor deposition) method, a plasma CVD method, and a photo-CVD method. Preferred examples of a method of forming a dielectric layer include a bar coating method, a roll-knife coating method, a gravure coating method, a knife coating method, a spin coating method, a dip coating method, a screen printing method, a slide coating method, and a spraying method.

Material used for a 2nd electrode layer is not particularly limited as long as it is conductive material. Examples of such material include a metal film made of conductive paste or formed by physical deposition and the aforementioned material used for a 1st electrode layer. The thickness of a 2nd electrode layer is generally 50 to 50000 nm. Preferred examples of a method of forming a 2nd electrode layer include a bar coating method, a roll-knife coating method, a gravure coating method, a knife coating method, a spin coating method, a dip coating method, a screen printing method, a slide coating method, and a spraying method.

After a 2nd electrode layer is formed, an adhesive sheet or the like that serves as a protective layer used for a 2nd electrode layer is applied to a 2nd electrode layer such that a sheet capable of causing luminescence having an illuminated face that is one surface of a transparent substrate can be obtained.

If necessary, a design can be imparted to an illuminated face by directly printing a pattern, text, or the like on a transparent substrate with the use of, for example, a translucent color ink and a color filter or by applying an adhesive sheet subjected to printing with a translucent color ink to a transparent substrate.

The thickness of a sheet capable of causing luminescence is preferably 5 mm or less and more preferably 0.2 to 2 mm.

The low-power-consuming luminescent sheet of the present invention can be obtained by allowing the above sheet capable of causing luminescence to be subjected to perforation processing.

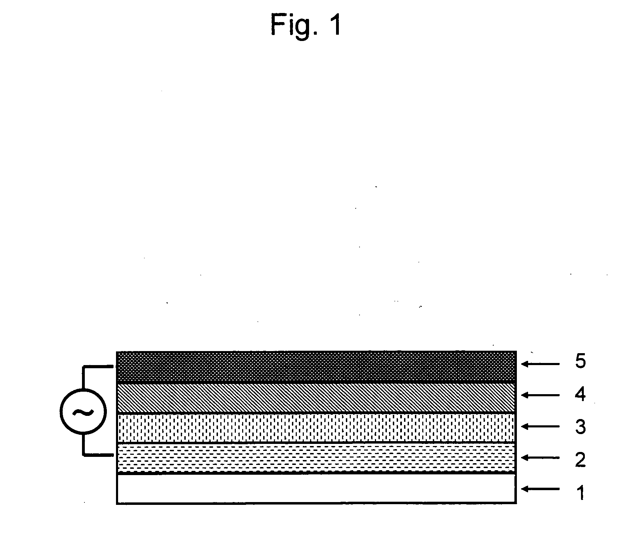

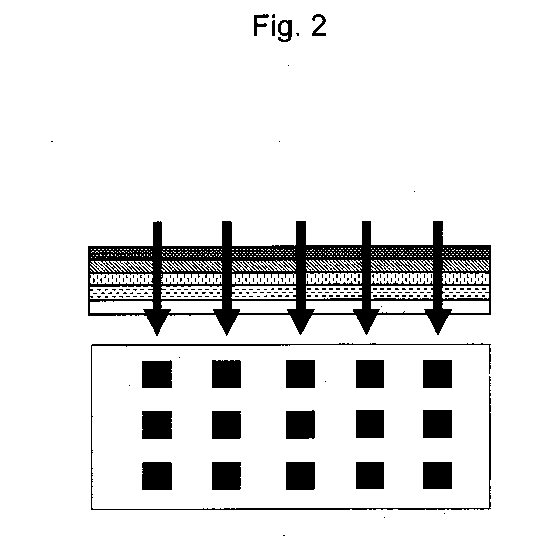

Fig. 1 shows a cross-sectional view of an unperforated luminescent sheet, such luminescent sheet obtained by providing a 1st electrode (transparent electrode) layer 2, a luminescence layer 3, a dielectric layer 4, and a 2nd electrode (back-side electrode) layer 5 on a transparent substrate 1. Fig. 2 shows a state in which perforation processing is carried out from the 2nd electrode (back-side electrode) layer 5 side.

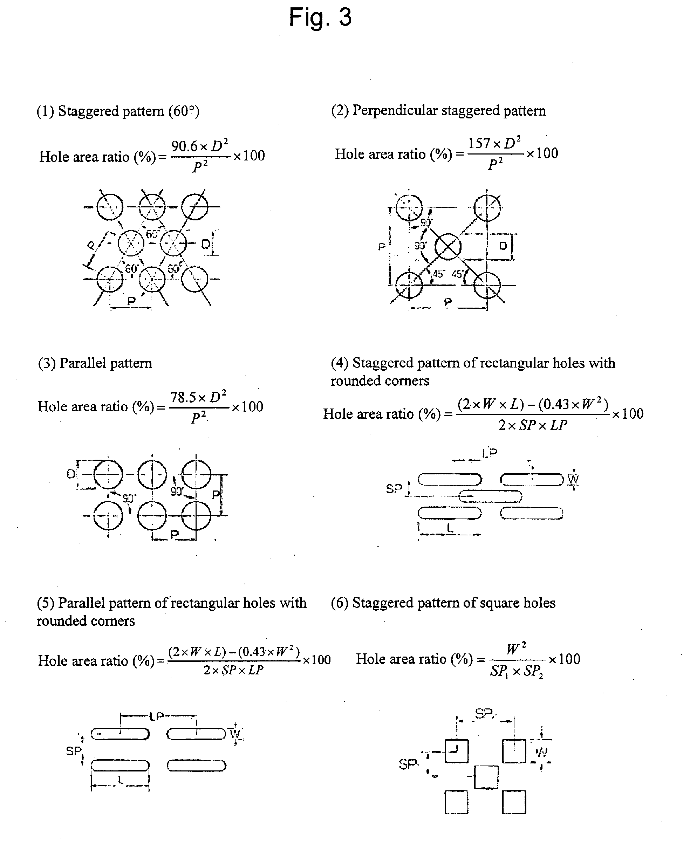

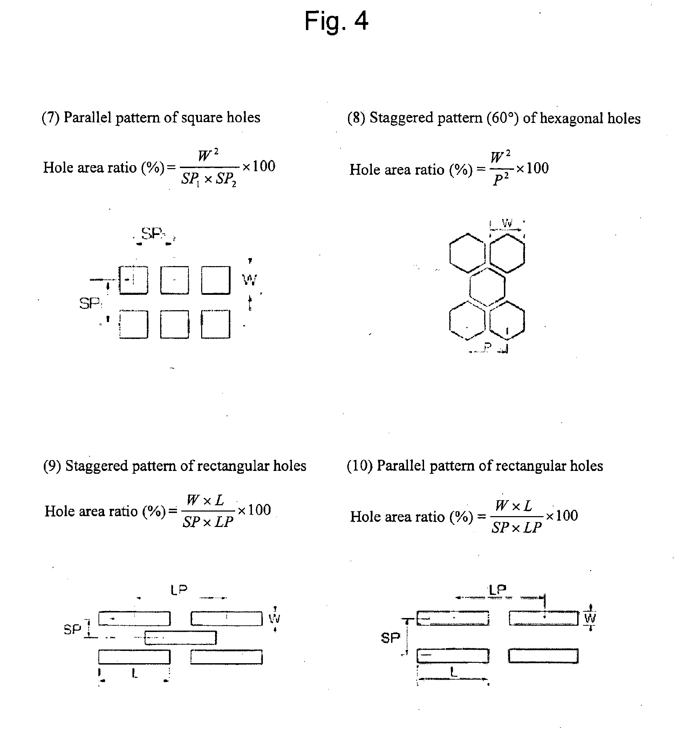

Perforation processing may be carried out in a manner such that holes have a desired shape and size. However, in order to achieve uniform luminescence, perforation processing is preferably carried out in a manner such that holes with a uniform size are arranged in parallel at equal intervals in a matrix pattern (e.g., a staggered pattern (60°), a perpendicular staggered pattern, a parallel pattern, a staggered pattern of rectangular holes with rounded corners, a parallel pattern of rectangular holes with rounded corners, a staggered pattern of square holes, a parallel pattern of square holes, a staggered pattern (60°) of hexagonal holes, a staggered pattern of rectangular holes, or a parallel pattern of rectangular holes (see figs. 3 and 4)).

Examples of the hole shape include, but are not particularly limited to, round shapes, oval shapes, triangular shapes, rectangular shapes, polygonal shapes, and star shapes. The diameter of a hole made by perforation processing is not particularly limited; however, it is generally 0.1 to 20 mm and preferably 0.5 to 10 mm in terms of practical use. The length of the interval between the centers of holes is generally 0.2 to 50 mm, preferably 0.2 to 20 mm, and further preferably 0.5 to 10 mm.

The hole area ratio is preferably 5% to 80% and more preferably 10% to 60% in order to prevent luminosity reduction caused by perforation processing and to achieve low power consumption. The term "hole area ratio" used herein indicates the percentage (%) of the total area of holes on the sheet area. When perforation processing is carried out uniformly, the hole area ratio can be calculated by the following formula: [(single hole area x number of holes) x 100 / sheet area].

Further, the hole shape, the hole diameter, the length of the interval between the centers of holes, and the hole area ratio are selected according to need. Thus, a luminescent sheet having a reverse face to which a see-through effect (transparency) is imparted can be obtained.

Examples of a means for perforation processing include, but are not particularly limited to; punching processing such as drilling, heated-needle processing, punching, flat die cutting (punching using a flat blade), or rotary die cutting (punching using a rotary blade); and laser processing using a carbon dioxide ($CO_2$) laser, a TEA-$CO_2$ laser, a YAG laser, a UV-YAG laser, an excimer laser, a semiconductor laser, a $YVO_4$ laser, a YLF laser, or a femtosecond laser.

The power consumption of the luminescent sheet of the present invention is generally over 0% and 90% or less and preferably 30% to 90% when the power consumption of an unperforated luminescent sheet is designated as 100%.

The luminosity of the luminescent sheet of the present invention is generally 50% to 100% and preferably 70% to 100% when the luminosity of an unperforated luminescent sheet is designated as 100%. When the above luminosity is 50% or more, sufficient visibility can be achieved.

The luminosity according to the present invention can be obtained by the following formula: luminosity = luminance (found value) x [sheet area - (single hole area x number of holes)].

In cases in which the luminescent sheet of the present invention is used as an advertising medium, a decorative medium, or a security sheet that is applied to signboards or windows of commercial buildings, vehicles, and the like, such luminescent sheet can be protected by applying a protective sheet to both sides thereof. Such protective adhesive sheet to be used is not particularly limited as long as it is transparent. Preferably, an anti-scratch (hard-coating) treatment is carried out on such protective sheet. Furthermore preferably, such protective sheet has a barrier performance against gas (e.g., $H_2O$ or $O_2$). When such luminescent sheet is attached to a wall or a window, a variety of commercially available adhesives can be used.

Examples

The present invention is hereafter described in greater detail with reference to the following Examples and Comparative Example, although the technical scope of the present invention is not limited thereto.

In the following Examples and Comparative Example, power consumption values, power consumption ratios, luminances upon luminescence at a power consumption of 1 W, luminosities, and hole area ratios were measured and calculated as described below.

[Measurement of power consumption values and calculation of power consumption ratios]

Power consumption values of an unperforated luminescent sheet (Comparative Example) and a perforated luminescent sheet (Examples) were measured using a Wat Checker (Keisoku Giken Co., Ltd.).

$$\text{Power consumption value} = \text{Current (A)} \times \text{Voltage (V)} \times \text{Power factor}$$

In addition, the ratio of power consumption of a perforated luminescent sheet to that of an unperforated luminescent sheet (Comparative example 1) was designated as the power consumption ratio.

[Measurement of luminances and calculation of luminances upon luminescence at a power consumption of 1 w and luminosities]

The luminance of a non-hole portion of an unperforated luminescent sheet (Comparative example) and that of a perforated luminescent sheet (Examples) were measured using a luminance meter LS-100 (MINOLTA).
The luminance upon luminescence was obtained by the following formula based on the above luminance (found value (cd/m$^2$)):
luminance $\times$ [(100 - hole area ratio)/100]. Further, the luminance upon luminescence calculated by the above formula was divided by power consumption such that luminance upon luminescence per unit of power consumption was calculated. The luminosity (cd) was obtained by the following formula: [luminance $\times$ [sheet area - (single hole area $\times$ number of holes)]].

[Determination of hole area ratios]

Figs. 3 and 4 show how to determine hole area ratios derived from different perforation processing patterns. In the Examples below, hole area ratios were determined according to the formula used for the parallel pattern of square holes in fig. 4 (7). In addition, in figs. 3 and 4, the letters "D," "P," "SP," "LP," "W," and "L" represent round hole diameter, pitch, square-hole pitch (rectangular-hole pitch (short)), rectangular-hole pitch (long), hole width, and hole length (long), respectively.

[Example 1]

The present invention is explained below with reference to fig. 1.
A 1st electrode (transparent electrode) layer 2 (50 nm in thickness) was formed by ITO sputtering on a polyethylene terephthalate sheet 100 μm in thickness (DIAFOIL T-100, Mitsubishi Polyester Film Corporation) serving as a transparent substrate 1. Subsequently, a ZnS:Cu solution (FEL-190, Fujikura Kasei Co., Ltd.) was coated to the ITO face of the 1st electrode layer 2 such that a luminescent layer 3 was formed to have a thickness of 50 μm and dried using a dryer at 100°C for 30 minutes. Thereafter, a barium titanate solution (FEL-615, Fujikura Kasei Co., Ltd.) was further coated thereto such that a dielectric layer 4 was formed to have a thickness of 50μ m. Drying was carried out using a dryer at 100°C for 30 minutes as described above. Accordingly, a sheet was obtained. Subsequently, a conductive paste (FEC-198, Fujikura Kasei Co., Ltd.) was coated to the above dielectric layer (barium titanate) such that a 2nd electrode (back-side electrode) layer 5 was formed to have a thickness of 50 μm. The conductive paste was heated using a dryer at 100°C for 30 minutes for curing. An adhesive sheet (PET50 (A) PL SHIN, Lintec Corporation) was laminated thereto such that a sheet capable of causing luminescence was obtained.
The above sheet capable of causing luminescence (14 cm x 25 cm) was subjected to perforation processing using a CO$_2$ laser in a manner such that holes with a uniform hole size were arranged in parallel at equal intervals in a matrix pattern (hole shape: square (1 cm x 1 cm); length of the interval between the centers of holes: 22.5 mm; and hole area ratio: 20%). Accordingly, a luminescent sheet was produced. The power consumption value and the luminance upon luminescence of the luminescent sheet were measured at AC 100 V with 50 Hz. The luminance was 306 cd/m$^2$ In addition, the current was 0.08 A, the voltage was 103.3 V, and the power factor was 0.46.

[Example 2]

Perforation processing was carried out in the same manner as in Example 1 except that the length of the interval between the centers of holes was 18 mm (hole area ratio: 30%) while the hole diameter remained unchanged. Accordingly, a luminescent sheet was produced. The power consumption value and the luminance upon luminescence of the luminescent sheet were measured at AC 100 V with 50 Hz. The luminance was 339 cd/m$^2$. In addition, the current was 0.07 A, the voltage was 102.8 V, and the power factor was 0.44.

[Example 3]

Perforation processing was carried out in the same manner as in Example 1 except that the length of the interval between the centers of holes was 14 mm (hole area ratio: 50%) while the hole diameter remained unchanged. Accordingly, a luminescent sheet was produced. The power consumption value and the luminance upon luminescence of the luminescent sheet were measured at AC 100 V with 50 Hz. The luminance was 399 cd/m$^2$ In addition, the current was 0.04 A, the voltage was 102.7 V, and the power factor was 0.64.

[Example 4]

Perforation processing was carried out in the same manner as in Example 1 except that the length of the interval between the centers of holes was 12 mm (hole area ratio: 70%) while the hole diameter remained unchanged. Accordingly, a luminescent sheet was produced. The power consumption value and the luminance upon luminescence of the luminescent sheet were measured at AC 100 V with 50 Hz. The luminance was 462 cd/m$^2$ In addition, the current was 0.02 A, the voltage was 102.0 V, and the power factor was 0.69.

[Comparative example 1]

The power consumption value and the luminance upon luminescence of an unperforated luminescent sheet were measured at AC 100 V and 50 Hz. The obtained luminance was 245 cd/m$^2$ In addition, the current was 0.11 A, the voltage was 103.1 V, and the power factor was 0.38.
Table 1 shows the results.

[Table 1]

| | Hole area ratio (%) | Power consumption (W) | Power consumption ratio (%) | Luminance (cd/m$^2$) | Luminance upon luminescence at a power consumption of 1 W | Luminosity (cd) |
|---|---|---|---|---|---|---|
| Example 1 | 20 | 3.8 | 88 | 306 | 64.4 | 8.57 |
| Example 2 | 30 | 3.2 | 74 | 339 | 74.2 | 8.31 |
| Example 3 | 50 | 2.6 | 60 | 399 | 76.7 | 7.00 |
| Example 4 | 70 | 1.4 | 33 | 462 | 99.0 | 4.85 |
| Comparative Example 1 | 0 | 4.3 | 100 | 245 | 57.0 | 8.57 |

Based on the results shown in table 1, it was confirmed that perforation processing caused reduction in the power consumption of a luminescent sheet. In addition, in each Example, the obtained luminance upon luminescence at a power consumption of 1 W was higher than that obtained in the case of the luminescent sheet of Comparative example 1. Further, the rate of luminosity reduction was significantly lowered even with an increased hole area ratio. Thus, the luminescent sheet of the present invention was confirmed to have excellent properties so as to serve as a low-power-consuming-luminescent sheet.
The luminescent sheet of the present invention can be used in a variety of fields relating to advertising media, decorative media, security sheets, lighting applications, backlight applications, and the like.

**Claims**

1.  A luminescent sheet according to either claim 1 or claim 2, wherein the hole area ratio is luminescence to be subjected to perforation processing.

2.  The luminescent sheet according to claim 1, wherein the sheet capable of causing luminescence is an electroluminescent sheet.

**3.** The luminescent sheet according to either claim 1 or claim 2, wherein the hole area ratio is 5% to 80%.

**4.** The luminescent sheet according to any one of the preceding claims, wherein the hole diameter upon perforation processing is 0.1 to 20 mm and the length of the interval between the centers of holes is 0.2 to 50 mm.

**5.** The luminescent sheet according to any one of the preceding claims, which has been subjected to perforation processing in a matrix pattern.

**6.** A method of producing the luminescent sheet according to claim 1, comprising allowing a sheet capable of causing luminescence to be subjected to perforation processing.

**7.** The method according to claim 6, wherein the means of perforation processing used is drilling, heated-needle processing, punching, flat die cutting, rotary die cutting, or laser processing.

# Fig. 1

Fig. 2

# Fig. 3

(1) Staggered pattern (60°)

Hole area ratio (%) $= \dfrac{90.6 \times D^2}{P^2} \times 100$

(2) Perpendicular staggered pattern

Hole area ratio (%) $= \dfrac{157 \times D^2}{P^2} \times 100$

(3) Parallel pattern

Hole area ratio (%) $= \dfrac{78.5 \times D^2}{P^2} \times 100$

(4) Staggered pattern of rectangular holes with rounded corners

Hole area ratio (%) $= \dfrac{(2 \times W \times L) - (0.43 \times W^2)}{2 \times SP \times LP} \times 100$

(5) Parallel pattern of rectangular holes with rounded corners

Hole area ratio (%) $= \dfrac{(2 \times W \times L) - (0.43 \times W^2)}{2 \times SP \times LP} \times 100$

(6) Staggered pattern of square holes

Hole area ratio (%) $= \dfrac{W^2}{SP_1 \times SP_2} \times 100$

# Fig. 4

(7) Parallel pattern of square holes

$$\text{Hole area ratio (\%)} = \frac{W^2}{SP_1 \times SP_2} \times 100$$

(8) Staggered pattern (60°) of hexagonal holes

$$\text{Hole area ratio (\%)} = \frac{W^2}{P^2} \times 100$$

(9) Staggered pattern of rectangular holes

$$\text{Hole area ratio (\%)} = \frac{W \times L}{SP \times LP} \times 100$$

(10) Parallel pattern of rectangular holes

$$\text{Hole area ratio (\%)} = \frac{W \times L}{SP \times LP} \times 100$$

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11045062 A
- JP 2005108776 A
- JP 2002196705 A